# EUROPEAN PATENT APPLICATION

(11) **EP 4 760 311 A1**
(43) Date of publication of application: **17.06.2026**
(21) Application number: 25222834.1
(22) Date of filing: 12.12.2025
(51) Int. Cl.: G01R 31/392, G01R 31/396

(54) **SYSTEM FOR ANALYZING BATTERY CELL PERFORMANCE AND METHOD OF ANALYZING BATTERY CELL PERFORMANCE USING THE SAME**

(30) Priority: 13.12.2024 KR 20240186536
(71) Applicant: SAMSUNG SDI CO., LTD., Yongin-si, Gyeonggi-do 17084 (KR)
(72) Inventor: JOE, YeongBeom, 17084 Yongin-si, Gyeonggi-do (KR); RYU, Miran, 17084 Yongin-si, Gyeonggi-do (KR); HWANG, Yubin, 17084 Yongin-si, Gyeonggi-do (KR); KIM, Hyeonwoo, 17084 Yongin-si, Gyeonggi-do (KR)
(74) Representative: Gulde & Partner

(57) **Abstract**

Disclosed herein are a system for analyzing battery cell performance and a method of analyzing battery cell performance using the same. The system for analyzing battery cell performance includes a process equipment data management unit (520) configured to transmit equipment data, a data analysis and model management unit (510) configured to create and manage, based on the equipment data, a battery model including a base reference model (511) and an extended reference model (512), and a cell abnormality evaluation unit (530) configured to determine whether there is an abnormal cell using the battery model.

## Description

### BACKGROUND

### 1. Technical Field

The present disclosure relates to a system for analyzing battery cell performance and a method of analyzing battery cell performance using the same.

### 2. Related Art

Checking for presence or absence of abnormalities in battery cells is an essential process for stable cell production.

Conventionally, it is difficult to identify in advance presence or absence of abnormalities in cells with simple evaluation analysis methods used to determine whether there are abnormal cells.

When a wide range of risk margins is utilized to address safety issues, a lot of cost may be incurred as usable cells are discarded.

### SUMMARY

Accordingly, an object of the present disclosure is to provide a system and method for analyzing battery cell performance, which are capable of performing determination of defective cells using base and extended reference models, thereby combining data obtained during manufacturing of cells in manufacturing equipment in real time with battery models to complexly analyze individual battery statuses of each lot and its product in real time.

However, the technical problem to be solved by the present invention is not limited to the problems described above, and other problems not mentioned herein will be clearly understood by those skilled in the art from the following detailed description of the invention.

In accordance with an aspect of the present disclosure, there is provided a system for analyzing battery cell performance, which includes a process equipment data management unit configured to transmit equipment data, a data analysis and model management unit configured to create and manage, based on the equipment data, a battery model including a base reference model and an extended reference model, and a cell abnormality evaluation unit configured to determine whether there is an abnormal cell using the battery model.

The process equipment data management unit may collect and classify the equipment data according to lot production progress, and may convert and transmit the equipment data.

The data analysis and model management unit may create and manage the battery model, which may include an electrochemical model and an equivalent circuit model.

The data analysis and model management unit may update the battery model based on the result of battery evaluation (e.g., in manufacturing equipment).

The data analysis and model management unit may construct the base reference model based on cell data accumulated before mass production.

The data analysis and model management unit may receive process-specific measurement data to construct the extended reference model.

The data analysis and model management unit may receive formation process measurement data to additionally create a prediction model for each sample.

The cell abnormality evaluation unit may determine whether there is an abnormal cell using the equipment data and the battery model, and may transmit a result of the determination to an operator terminal.

The data analysis and model management unit may create the extended reference model based on at least one of cell information, plate information, and form factor information, which may be accumulated during manufacturing of cells.

The data analysis and model management unit may output a different model for each sample by a digital twin application.

The cell abnormality evaluation unit may output risk factor information that may include at least one of output, heating, and deterioration information.

If a result of defective cell determination using the extended reference model based on the equipment data does not match a result of defective cell determination using the extended reference model based on formation evaluation data, the cell abnormality evaluation unit may perform final defective cell determination by giving relatively high reliability to the formation evaluation data.

In accordance with another aspect of the present disclosure, there is provided a method of analyzing battery cell performance, which includes (a) constructing a base reference model for analysis of battery cell performance, (b) constructing an extended reference model by exchanging data with process equipment, (c) constructing a prediction model for each sample based on formation process evaluation data, and (d) determining whether there is an abnormal cell using the base reference model, the extended reference model, and the prediction model for each sample.

In the step of (a) constructing a base reference model, the base reference model may be constructed based on cell data accumulated before mass production.

In the step of (b) constructing an extended reference model, the extended reference model may be constructed based on process-specific measurement data.

In the step of (b) constructing an extended reference model, the extended reference model may be constructed based on at least one of cell information, plate information, and form factor information.

In the step of (c) constructing a prediction model for each sample, performance characteristics for each sample may be extracted based on formation process evaluation data, and the prediction model for each sample may be constructed that is specialized for battery cells.

In the step of (d) determining whether there is an abnormal cell, a result of the determination of whether there is an abnormal cell may be output by outputting risk factor information, which may include at least one of output, heating, and deterioration information.

In the step of (d) determining whether there is an abnormal cell, if a result of abnormal cell determination using the base reference model does not match a result of abnormal cell determination using the extended reference model, a final evaluation result may be output by giving relatively high reliability to the result of abnormal cell determination using the extended reference model.

In accordance with a further aspect of the present disclosure, there is provided a system for analyzing battery cell performance, which includes an input interface device configured to receive equipment data, a memory configured to store a program for creating and managing a battery model for analysis of battery cell performance based on the equipment data (e.g., by implementing a method according to present disclosure), and a processor configured to execute the program, wherein the processor is configured (e.g., by the program) to determine whether there is an abnormal cell using the battery model including a base reference model and an extended reference model.

In accordance with a further aspect of the present disclosure, there is provided a computer program comprising instructions which, when the program is executed by a computer, cause the computer to carry out a method according to present disclosure.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present disclosure.

### BRIEF DESCRIPTION OF THE DRAWINGS

The following drawings illustrate example embodiments of the present disclosure, and further describe example aspects of the present disclosure together with the detailed description of the present disclosure. Thus, the present disclosure should not be construed as being limited to the drawings:
FIG. 1 schematically illustrates an electrode assembly of a secondary battery;
FIG. 2 schematically illustrates a configuration of a pouch-type secondary battery;
FIG. 3 illustrates a schematic external appearance configuration of a prismatic secondary battery;
FIG. 4 is a cross-sectional view of a cylindrical secondary battery;
FIG. 5 illustrates a system for analyzing battery cell performance according to an embodiment of the present disclosure;
FIG. 6 is a chart illustrating a charge amount and time accuracy using 6C rapid stack cells through base reference model acceleration according to the embodiment of the present disclosure;
FIG. 7 illustrates an extended reference model configuration according to the embodiment of the present disclosure;
FIG. 8 is a profile data analysis graph of a prediction model for each process completion sample according to the embodiment of the present disclosure;
FIG. 9 is a graph related to consistency improvement using the prediction model for each process completion sample according to the embodiment of the present disclosure;
FIG. 10 illustrates a method of analyzing battery cell performance according to an embodiment of the present disclosure;
FIG. 11 is a block diagram illustrating a computer system for implementing the method according to the embodiment of the present disclosure;
FIG. 12 is an example view of a secondary battery module in which secondary batteries manufactured according to examples of the present disclosure are arranged.
FIG. 13 is an example view of a secondary battery pack including the secondary battery module illustrated in FIG. 21; and
FIG. 14 is a conceptual view of a vehicle including the secondary battery pack illustrated in FIG. 13.

### DETAILED DESCRIPTION

Hereinafter, example embodiments of the present disclosure will be described, in detail, with reference to the accompanying drawings. The terms or words used in the present specification and claims are not to be limitedly interpreted based on their general or ordinary meaning, and should be interpreted as meanings and concepts that are consistent with the technical idea of the present disclosure on the basis of the principle that an inventor can be their own lexicographer to appropriately define concepts of terms to describe their disclosure in the best way.

The example embodiments described in this specification and the configurations shown in the drawings are only some example embodiments of the present disclosure and do not represent all of the aspects of the present disclosure. Accordingly, it should be understood that there may be various equivalents and modifications that can replace or modify one or more example embodiments described herein at the time of filing this application.

It will be understood that if an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, if a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges is within the scope of this disclosure as defined in the appended claims.

References to two compared elements, features, etc. As being "the same" may mean that they are "substantially the same." Thus, the phrase "substantially the same" may include a circumstance having a deviation that is considered low in the art, for example, a deviation of 5% or less. In addition, if a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

Throughout the specification, if "A and/or B" is stated, it means A, B or A and B, unless otherwise stated. That is, "and/or" includes any or all combinations of a plurality of items enumerated. When "C to D" is stated, it means C or more and D or less, unless otherwise specified.

When the terms "about" or "substantially" are used in this specification in connection with a numerical value, it is intended that the associated numerical value include a tolerance of ±10% around the stated numerical value. When ranges are specified, the range includes all values therebetween such as increments of 0.1%.

The terminology used herein is for the purpose of describing example embodiments of the present disclosure and is not intended to limit the present disclosure.

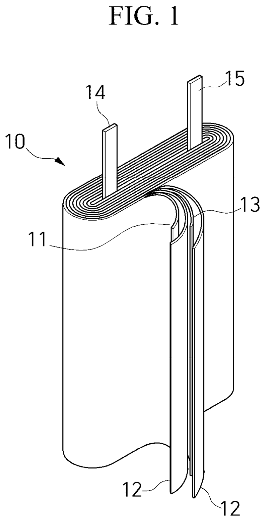

FIG. 1 schematically illustrates an electrode assembly built in a case of a secondary battery.

An electrode assembly 10 may be formed by winding or stacking a stack of a first electrode plate 11, a separator 12, and a second electrode plate 13, which are formed as thin plates or films. When the electrode assembly 10 is a wound stack, a winding axis may be parallel to the longitudinal direction (e.g., the y direction) of the case 59. In other example embodiments, the electrode assembly 10 may be a stack type rather than a winding type, and the shape of the electrode assembly 10 is not limited in the examples of the present disclosure. In addition, the electrode assembly 10 may be or include a Z-stack electrode assembly in which a positive electrode plate and a negative electrode plate are inserted into both sides of a separator, which is then bent into a Z-stack. In addition, one or more electrode assemblies may be stacked such that long sides of the electrode assemblies are adjacent to each other and accommodated in the case, and the number of electrode assemblies in the case is not limited in the examples of the present disclosure. The first electrode plate 11 of the electrode assembly may act as a negative electrode, and the second electrode plate 13 may act as a positive electrode. In examples, the reverse is also possible.

The first electrode plate 11 may be formed by applying a first electrode active material, such as graphite or carbon, to a first electrode current collector formed of a metal foil, such as copper, a copper alloy, nickel, or a nickel alloy. The first electrode tab 14 may be connected to an external first terminal (not shown). In some example embodiments, when the first electrode plate 11 is manufactured, the first electrode tab 14 may be formed by being cut in advance to protrude to one side of the electrode assembly 10, or the first electrode tab 14 may protrude to one side of the electrode assembly 10 more than, e.g., farther than or beyond, the separator 12 without being separately cut.

The second electrode plate 13 may be formed by applying a second electrode active material, such as a transition metal oxide, on a second electrode current collector formed of or including a metal foil, such as aluminum or an aluminum alloy. The second electrode plate 13 may include a second electrode tab 15 (e.g., a second uncoated portion) that is or includes a region to which the second electrode active material is not applied. The second electrode tab 15 may be connected to an external second terminal (not shown). In some example embodiments, the second electrode tab 15 may be formed by being cut in advance to protrude to the other side (e.g., the opposite side) of the electrode assembly 10 when the second electrode plate 13 is manufactured, or the second electrode plate 13 may protrude to the other side of the electrode assembly more than, e.g., farther than or beyond, the separator 12 without being separately cut.

In some example embodiments, the first electrode tab 14 may be located on the left side of the electrode assembly 10, and the second electrode tab 15 may be located on the right side of the electrode assembly 10. In other example embodiments, the first electrode tab 14 and the second electrode tab 15 may be located on one side of the electrode assembly 10 in the same direction.

Here, for convenience of description, the left and right sides are defined according to the electrode assembly 10 as oriented in FIG. 1, and the positions thereof may change when the secondary battery is rotated left and right or up and down.

The separator 12 hinders or substantially prevents a short-circuit between the first electrode plate 11 and the second electrode plate 13 while allowing movement of lithium ions therebetween. The separator 12 may be made of or include, for example, a polyethylene film, a polypropylene film, a polyethylene-polypropylene film, etc.

In some example embodiments, the electrode assembly 10 may be accommodated in the case (not shown) along with an electrolyte. In the circumstance of a pouch-type secondary battery, an electrode assembly 10 may be accommodated in a pouch made of or including flexible material in the form illustrated in FIG. 1. In the circumstance of a prismatic secondary battery, an electrode assembly 10 may be accommodated in a prismatic metal casing in the form illustrated in FIG. 1.

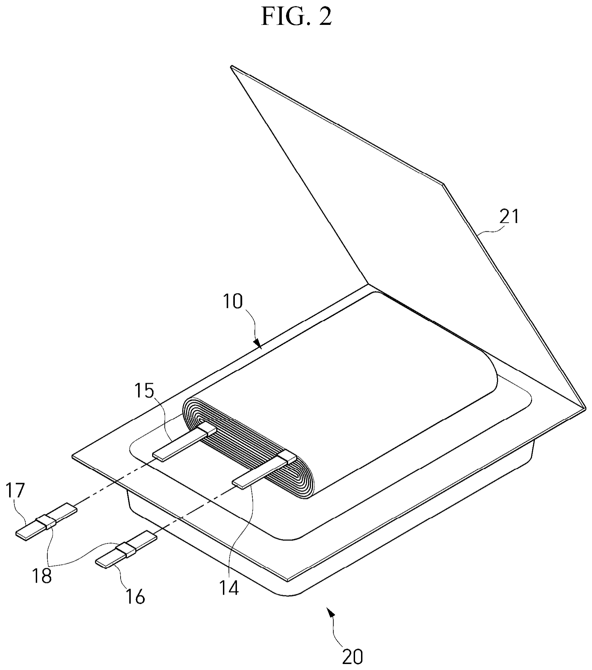

FIG. 2 schematically illustrates the pouch-type secondary battery.

The pouch-type secondary battery includes an electrode assembly 10 and a pouch 20 that accommodates or contains the electrode assembly 10 therein.

The electrode assembly 10 may be the same as the electrode assembly 10 illustrated in FIG. 1. The first electrode tab 14 and the second electrode tab 15 of the electrode assembly 10 may be electrically connected to respective external first and second terminal leads 16 and 17 by ,e.g., welding or other attaching method that preserves conductivity therebetween. At least a portion of each of the first terminal lead 16 and the second terminal lead 17 may be attached or covered with a tab film 18 for insulation from the pouch 20.

The pouch 20 may be sealed by having sealing parts 21 at the edges thereof come into contact with each other while accommodating or containing the electrode assembly 10 therein, in which circumstance the sealing may be achieved with the tab film 18 interposed between the sealing parts 21. The sealing parts 21 of the pouch 20 may be made of or include a thermal fusion material that generally has weak adhesion to metal. Thus, it may be fused to the pouch 20 by interposing the thin tab film 18 between the sealing parts 21.

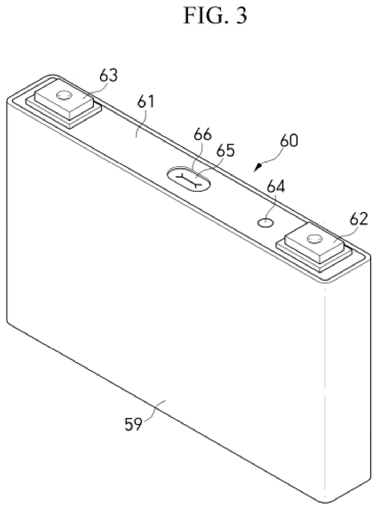

FIG. 3 illustrates a schematic external appearance configuration of a prismatic secondary battery.

A prismatic case 51 defines an overall appearance of the prismatic secondary battery, and may be made of or include a conductive metal, such as aluminum, aluminum alloy, or nickel-plated steel. In addition, the case 51 may provide a space for accommodating or containing the electrode assembly 10 therein.

A cap assembly 60 may include a cap plate 61 that covers an opening of the case 51, and the case 51 and the cap plate 61 may be made of or include a conductive material. A first terminal 63 and a second terminal 62 may be electrically connected to the first electrode tab 14 and the second electrode tab 15 of the electrode assembly 10 illustrated in FIGS. 1 and 2 inside the case 51, and may be installed to protrude outward through the cap plate 61.

The cap plate 61 may be equipped with or include an electrolyte injection port 64 configured to install a sealing plug therein, and a vent 66 formed that includes a notch 65 may be installed. The vent 66 is configured to discharge any gas generated inside the secondary battery.

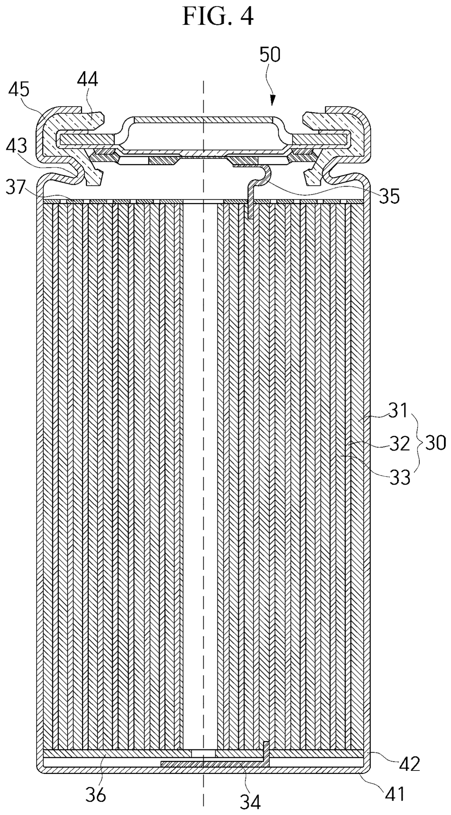

FIG. 4 is a cross-sectional view of a cylindrical secondary battery.

The cylindrical secondary battery includes an electrode assembly 30, a case accommodating the electrode assembly 30 and an electrolyte therein, a cap assembly 50 coupled to an opening of the case to seal the case, and an insulating plate 37 located between the electrode assembly 30 and the cap assembly 50 inside the case.

The electrode assembly 30 may include a separator 32 between a first electrode 33 and a second electrode 31, and the electrode assembly 30 may be wound in a jelly-roll form.

The first electrode 33 may include a first substrate and a first active material layer located on the first substrate. A first lead tab 35 may extend outward from a first uncoated portion of the first substrate where the first active material layer is not located, and may be electrically connected to the cap assembly 50.

The second electrode 31 may include a second substrate and a second active material layer located on the second substrate. A second lead tab 34 may extend outward from a second uncoated portion of the second substrate where the second active material layer is not located, and may be electrically connected to the case. The first lead tab 35 and the second lead tab 34 may extend in opposite directions with respect to each other.

The first electrode 33 may constitute a positive electrode. In this circumstance, the first substrate may be composed of or include, for example, aluminum foil, and the first active material layer may include, for example, a transition metal oxide. The second electrode 31 may constitute a negative electrode. In this case, the second substrate may be composed of or include, for example, copper foil or nickel foil, and the second active material layer may include, for example, graphite.

The separator 32 may reduce or prevent a short-circuit between the first electrode 33 and the second electrode 31 while allowing movement of lithium ions therebetween. The separator 32 may be made of or include, for example, at least one of a polyethylene film, a polypropylene film, a polyethylene-polypropylene film, etc.

The case accommodates or contains the electrode assembly 30 and the electrolyte, and substantially forms the external appearance of the secondary battery together with the cap assembly 50. The case may have a substantially cylindrical body portion 42, and a bottom portion 41 connected to one side of the body portion 42. A beading part 43 deformed inwardly may be formed in the body portion 42, and a crimping part 45 bent inwardly may be formed at an open end of the body portion 42.

The beading part 43 may reduce or prevent movement of the electrode assembly 30 inside the case, and may facilitate seating of a gasket 44 and the cap assembly 50. A crimping part 45 may firmly fix the cap assembly 50 by pressing the edge of the cap assembly 50 against the gasket 44. The case may be formed of or include iron plated with nickel, for example.

The cap assembly 50 may be fixed to the inside of the crimping part 45 through the gasket 44 to seal the case. The cap assembly 50 may include a cap up, a safety vent, a cap down, an insulating member, and a subplate, but is not limited to this example and may be variously modified.

The cap up may be located at the very top of the cap assembly 50. The cap up may include a terminal portion that protrudes convexly upward and is connected to an external circuit, and an outlet for discharging gas may be located around the terminal portion.

The safety vent may be located below the cap up. The safety vent may include a protrusion that protrudes convexly downward and is connected to the subplate, and at least one notch located around the protrusion.

When gas is generated due to overcharging or abnormal operation of the secondary battery, the protrusion may be deformed upward by pressure and may separate from the subplate, while the safety vent may be cut along the notch. The cut safety vent may hinder or prevent the secondary battery from exploding by discharging gas to the outside.

The cap down may be located below the safety vent. The cap down may be formed with a first opening for exposing the protrusion of the safety vent and a second opening for discharging gas. The insulating member may be located between the safety vent and the cap down to insulate the safety vent and the cap down.

The subplate may be located below the cap down. The subplate may be fixed to a lower surface of the cap down to block the first opening of the cap down, and the protrusion of the safety vent may be fixed to the subplate. The first lead tab 35 pulled out from the electrode assembly 30 may be fixed to the subplate. Accordingly, the cap up, the safety vent, the cap down, and the subplate may be electrically connected to the first electrode 33 of the electrode assembly 30.

The insulating plate 37 may be located below the beading part 43 to be in contact with the electrode assembly 30, and may be provided with a tab opening for pulling out the first lead tab 35. The cap assembly 50, which is electrically connected to the first electrode 33 by the first lead tab 35, may face the electrode assembly 30 with the insulating plate 37 interposed therebetween, and may maintain an insulated state from the electrode assembly 30 by the insulating plate 37. On the other hand, another insulating plate 36 may be included for insulation between the electrode assembly 30 and the bottom portion 41 of the case.

In the following, the background of the proposed invention will be explained to help those skilled in the art understand, and embodiments of the present disclosure will be described.

In the field of battery manufacturing technology, checking for presence or absence of abnormalities in batteries in advance during the production thereof is essential for stable cell production.

Conventionally, battery production facilities introduce simple evaluation analysis methods to determine presence or absence of abnormalities in cells.

However, it is difficult to identify presence or absence of abnormalities in cells with high reliability using the simple evaluation analysis methods, so businesses utilize a very wide range of risk margins to address safety issues.

It can be seen as one efficient management method, but cost issues may be incurred as a large number of usable cells are discarded.

In order to reduce cell manufacturing costs, it is important to reduce the number of cells that is unnecessarily discarded. The present disclosure has a technical feature that enables complex analysis of battery statuses with high reliability through the combination of manufacturing equipment and battery models in real time.

The electrical/thermal characteristic simulation model of each battery and the thermal model of each battery cell will be described below.

The electrochemical model of the battery is a model that explains chemical reactions and electrical characteristics that take place in the battery, and is classified into an ion migration model, an electrode reaction model, and an electrolyte model.

The equivalent circuit model (ECM) of the battery cell mimics various electrochemical phenomena using equivalent circuit model technology. The equivalent circuit model is created by combining an equivalent resistance, an equivalent voltage source, an equivalent current source, etc., and is developed as a model that mimics output equivalent to actual cells through parameter characterization work. It has a fast and stable model structure that allows output prediction to respond in a short period of time under different conditions.

The thermal model of the battery cell is a model that infers a change in temperature during the electrical behavior of the battery, and is used in combination with the electrochemical model and the equivalent circuit model. The thermal model of the battery cell predicts the change in temperature of the battery through characterization under different conditions such as by F/F, cooling, module configuration, and actual usage environment.

In the following, battery manufacturing equipment will be described.

The battery is manufactured in three major stages: a plate process, an assembly process, and a formation process. In the plate process, positive and negative electrodes that are inserted into the battery are made. In the assembly process, after the positive and negative electrodes and a separator are rolled or stacked in a metal can or pouch, an electrolyte is put thereinto. In the formation process, charging/discharging and final inspection are performed. The plate process is the same for all three types of cylindrical, prismatic, and pouch-type batteries, but the assembly process and the formation process differ depending on the type of batteries.

The plate process is a process of making the positive and negative electrodes among the constituent positive and negative electrodes, separator, and electrolyte of the battery. This process is largely divided into mixing, coating, pressing, and slitting. The mixing is performed because it is necessary to produce a composite (mixture) to be coated on metal materials that will become the positive and negative electrodes. The composite (slurry) is produced by mixing an active material that improves the electrical performance of the positive and negative electrodes with a material (conductive material) that enables electrical conduction well and an adhesive (binder) that allows materials to adhere well to the metal materials. The composite is coated on aluminum and copper plates, which are the substrates of the positive and negative electrodes. The pressing is to compress the composite to ensure that it adheres well to the metal plates, reducing its thickness to increase the adhesion to the density substrates of the electrodes and facilitating the entry and exit of ions. After the slitting is then performed to cut the plates to fit their size, moisture and the like are removed therefrom. A system may automatically store various pieces of data measured during manufacturing of battery plates in the plate process, and check information about abnormalities in batteries at an early stage based on the stored information and accumulated information.

The assembly process is a process of making a battery by inserting the separator between the positive and negative plates that have been subjected to the plate process, wherein the separator is sequentially stacked between the positive and negative electrodes, and then rolled up by winding methods or piled up by stacking methods to make a jelly roll or stack, which is the intermediate form of the battery. This intermediate-form battery is welded or sealed after placed in the metal can or wrapped in the pouch, and injected with the electrolyte thereinto, so the assembly process is completed. In the assembly process that is operated automatically, if a value different from the preset value is monitored for each step, a warning is provided through an error notification in the manufacturing line so that defective cells are automatically classified. The process information obtained in the assembly process is also stored and managed like the data obtained in the plate process, and is utilizable by the system.

The formation process is a finishing process of activating the assembled battery to have electrical characteristics and identifying whether it is defective, wherein the lithium-ion battery immediately after the assembly process may be activated through charging, since its voltage measurement is impossible, in order to function as a battery. The formation process is subjected to charging/discharging, stabilization, classification, and defect sorting. The charging/discharging is to activate a discharged battery with initial charge, and accounts for 80% or more of the formation process. In this case, a thin solid electrolyte interphase (SEI) layer is formed on the surface of the negative electrode. The formation of the thin solid electrolyte interphase is very important in the formation process because it plays a critical role in the performance and lifespan of the battery. The stabilization is represented as aging in the field, wherein the electrolyte is stored for a certain period of time at a set temperature and humidity for stabilization after activation. In this case, the electrolyte needs to be evenly distributed inside the battery to optimize the migration of lithium ions. In the formation process, the charging/discharging is repeated and the voltage, resistance, capacity, and the like of the battery are measured and managed, which allows defective products to be selected so that they are not distributed to the outside.

A conventional battery process performs a simple evaluation of each battery and uses a numerical analysis method to determine presence or absence of an abnormality in each cell. The battery is produced by accumulating a lot of data during the process, and when there is data that deviates significantly from the reference data among various pieces of production information, the cell is discarded after checking whether it satisfies a certain condition, thereby providing high-quality products to customers. This method, however, increases cell manufacturing costs, and in order to solve the aforementioned, it is important to reduce the number of cells that is discarded.

Conventionally, it is determined whether a cell is abnormal through the final evaluation thereof by recording and analyzing various pieces of information related to situations occurring during the manufacturing process of the cell. If it is determined that a cell is defective during final manufacturing, the process data thereof is analyzed to identify presence or absence of an abnormality in processes, in order to improve the defect rate of the cell by improving a process that is determined as the cause of the abnormality.

However, this conventional method has clear limitations as a post-analytical method. Accordingly, in order to solve this issue, the present disclosure proposes a system and method for combining accumulated data with battery models and analyzing the performance of battery cells. The present disclosure also proposes an apparatus and method for combining data obtained during manufacturing of cells in manufacturing equipment in real time with battery models to complexly analyze individual battery statuses of each lot and its product in real time.

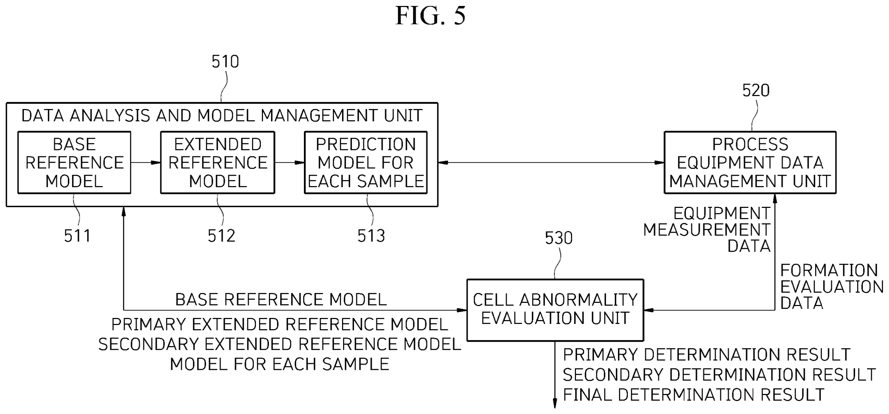

FIG. 5 illustrates a system for analyzing battery cell performance according to an embodiment of the present disclosure.

The system for analyzing battery cell performance according to the embodiment of the present disclosure includes a data analysis and model management unit 510, a process equipment data management unit 520, and a cell abnormality evaluation unit 530. The data analysis and model management unit 510 manages a battery model, and the battery model includes an electrochemical model and an equivalent circuit model, which are constructed based on the result of battery experiment. Based on the electrochemical model and the equivalent circuit model, an associated model is automatically changed for management depending on the result of battery evaluation in manufacturing equipment. The model is automatically improved by analyzing the consistency with actual evaluation data through machine learning using the electrochemical model, the equivalent circuit model, and the model that has been changed depending on the result of battery evaluation in the manufacturing equipment.

The battery evaluation according to the embodiment of the present disclosure is to check a deviation between battery cells and transmit a result of the check to each model. After performing an evaluation to check inter-cell deviation, by reflecting the inter-cell deviation into a prediction model, the prediction model may perform analysis on a risk of deterioration and a risk of stability based on only the deviation data for output of conclusions. In selecting evaluation data, it is basically to include all the data obtained in the formation process of the final completed cell. It is desirable to necessarily include voltage behavior during the formation of the cell, and it is possible to optionally include data on temperature behavior in addition to the voltage behavior. As an extension, it is possible to include all process information for the associated cell that is transferred to the formation process.

A lithium secondary battery has high energy density and charge/discharge efficiency, but if a lithium plating phenomenon occurs during the rapid charging of the battery, it causes uneven current distribution inside the battery, shortening its lifespan and, in severe cases, resulting in battery thermal runaway. Therefore, there is a need to prevent or minimize the lithium plating phenomenon during the rapid charging of the battery.

According to the embodiment of the present disclosure, it is possible to enhance the performance and stability of the battery during the rapid charging thereof by predicting lithium (Li) plating that may occur during the rapid charging of the lithium secondary battery and analyzing behavior in a low-rate voltage section to diagnose a possibility of the lithium plating in advance.

According to the embodiment of the present disclosure, it is possible to simultaneously ensure safety and efficiency by monitoring the voltage and current behaviors of the lithium secondary battery during the charging thereof in real time, analyzing a voltage change pattern that appears in the low-rate voltage section, i.e., a peak pattern, predicting the possibility of lithium plating in advance based on the result of analysis, and adjusting a charge profile if necessary. In relation to the analysis of the peak pattern, the minute change of the pattern is analyzed based on the voltage data collected in the low-rate voltage section during charging, and this data is processed with advanced data processing technology such as machine learning algorithms to quantitatively evaluate the possibility of lithium plating. This allows for identifying potential risk factors that may occur during rapid charging in advance.

A base reference model 511 is constructed based on cell data accumulated before mass production. An extended reference model 512 is constructed by receiving process-specific measurement data and based on information obtained for each lot during the process. A prediction model for each sample 513 is constructed by receiving formation process measurement data and by changing the resistance output of the model and the like to fit the logic based on information for each formation sample.

The cell data accumulated before mass production refers to all accumulated data on the plate or material accumulated in the research phase, and includes a simulation model developed based on associated information, as evaluation data of the developed cell (including data for both general evaluation and special evaluation). In the construction of major database, the accuracy of the database significantly affects the analysis of battery cell performance, and model-specific data is thus used in addition to actual development cells. The model-specific data includes at least one of the following: data to measure the charge/discharge behavior of the cell while minimizing the change in temperature within the pressurizer; data on the change in charge/discharge behavior of the cell depending on the pressure and/or temperature of the cell; initial life result data by temperature and pressure that is able to predict the deterioration of the cell; and voltage behavior analysis data for positive/negative half cells.

The formation process measurement data may include all information on formation environments, including, for example, information about where the formation process is performed. The formation process measurement data may include at least one of the following: data on the change in ambient temperature and the change in cell self-temperature; formation pattern information; information on cell voltage behavior analysis in formation patterns; voltage behavior information during initial charge/discharge after formation; and cell analysis data using special diagnostic patterns for formation-completed cells.

According to the embodiment of the present disclosure, the special diagnostic patterns are applied to the battery cell that has been subjected to the formation process to evaluate the performance and stability thereof in its initial state, which allows the quality and reliability of the battery to be enhanced. By analyzing the voltage behavior of the completed cell, which has been subjected to the formation process, under different environmental conditions, it is possible to systematically diagnose the performance of the cell and its stability to temperature, and the special diagnostic patterns are utilized for effective evaluation of battery characteristics.

The measurement pattern according to the change in temperature is used to measure charge/discharge characteristics while varying the temperature, in order to analyze the temperature vulnerability of the cell. This allows for checking whether the cell remains stable over a specific temperature section and evaluating the sensitivity to cell temperature.

The special diagnostic pattern for short-term evaluation that mimics customer-customized cooling environments is used to evaluate short-term performance while simulating the cooling conditions of the customer to be delivered in consideration of the actual usage environment. The charge/discharge characteristics of the cell are analyzed based on temperature and output data, and the suitability for the customer's usage environment is verified. The special diagnostic pattern for short-term voltage behavior evaluation that mimics in-module environments is used to reproduce the environment that may occur in the actual module and to evaluate the short-term voltage behavior of the cell under the associated conditions. In the process of cell analysis using the special diagnostic patterns, it is possible to measure the stability and performance of the cell to the change in temperature and output and to identify issues that may occur after module assembly in advance.

The process equipment data management unit 520 automatically collects and classifies data according to lot production progress, and converts the data into a certain format to continuously transmit it to the data analysis and model management unit 510.

The cell abnormality evaluation unit 530 uses the equipment data and the model to determine whether there is an abnormal cell and transmits a result of the determination to an operator terminal.

The data analysis and model management unit 510 accumulates and mixes cell information, plate information, and form factor information during manufacturing of each cell, and combines it with previously secured data to create a reference model. The reference model includes an electrochemical model or an equivalent circuit model. The created reference model is updated by the data accumulated between processes.

The data analysis and model management unit 510 combines cell evaluation data obtained from the assembly process or the formation process with data from the reference model to implement a different model for each sample on a computer. This is implemented by a digital twin application.

The cell abnormality evaluation unit 530 uses the model managed by the data analysis and model management unit 510 to evaluate each cell, and organizes and outputs the risk factors of the associated cell. The risk factors of the cell include at least one of output, heating, and deterioration information.

The cell abnormality evaluation unit 530 uses an evaluation analysis method based on the base reference model together to perform early determination on presence or absence of cell abnormalities under different conditions.

The process equipment data management unit 520 transmits existing data and actual measurement data to the data analysis and model management unit 510 and the cell abnormality evaluation unit 530.

The data analysis and model management unit 510 uses real-time equipment data to update models.

The cell abnormality evaluation unit 530 collects final data from the formation process, uses the model created by the data analysis and model management unit 510 to perform an evaluation test, and conducts risk analysis.

The cell abnormality evaluation unit 530 collects formation process data to conduct risk analysis through high-speed evaluation tests, wherein even if it is determined that a cell is defective through the extended reference model based on the equipment measurement data at primary determination, if it is determined that the cell is not defective through the extended reference model based on the formation evaluation data at secondary determination, it is ultimately determined that the cell is not defective.

In the following, the construction of the base reference model, the extended reference model, and the prediction model for each process completion sample will be described.

### CONSTRUCTION OF BASE REFERENCE MODEL

The base reference model is constructed based on a product before mass production, and is developed as a model capable of utilizing cell evaluation information obtained before mass production to mimic cell characteristics.

It is possible to shorten calculation time by using an automation module that creates and executes case files using a script for 3D modeling (thermal model).

According to the embodiment of the present disclosure, a machine learning-based rapid charging prediction model is constructed.

The X factor includes a cell resistance and a C-rate/cut-off voltage for each step charge stage, and the Y factor includes a 1st CC charge time, a 30-minute charge amount, a full charge time, and a lithium (Li) precipitation amount.

By inputting the X factor and outputting the Y factor, a machine learning model is developed through learning together with the result of the electrochemical model, and by inputting the Y factor and outputting the X factor, a protocol using deep learning is created.

The machine learning-based model is used as a base reference model, and for example, the optimal case for minimizing the lithium precipitation amount is explored, and the created model is used to create a protocol for response surface methods (RSMs).

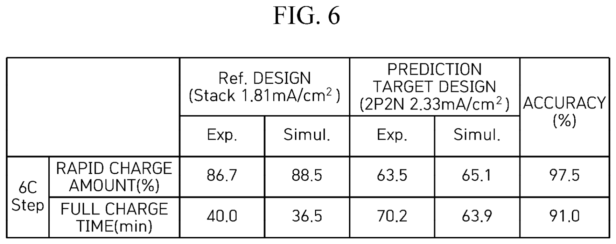

FIG. 6 is a chart illustrating a charge amount and time accuracy using 6C rapid stack cells through base reference model acceleration according to the embodiment of the present disclosure.

### CONSTRUCTION OF EXTENDED REFERENCE MODEL

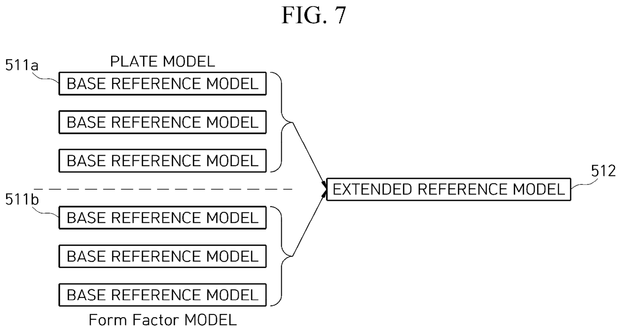

FIG. 7 illustrates an extended reference model configuration according to the embodiment of the present disclosure.

According to the embodiment of the present disclosure, the extended reference model is developed by databaseizing the previously secured base reference models 511a and 511b to create a model suitable for the provided cell design or by modifying the models.

In this case, the extended reference model 512 is constructed using multi-scale multi-dimensional (MSMD) based form factor prediction technology.

To overcome the shortcomings of the electrochemical model, the MSMD model is used to hierarchically classify the battery analysis domain into a particle level where microscopic physical phenomena occur, a plate level, and a cell level where macroscopic physical phenomena occur. In the analysis domain of the particle level, the behavior of lithium ions inside solid active material particles is modeled. In the analysis domain of the plate level, the behavior of voltage and current inside the plate is modeled through conservation equations for electrons and ions in the plate and electrolyte. In the analysis domain of the cell level, the behavior of temperature, current, and voltage of the entire cell including the plate substrate is modeled.

According to the embodiment of the present disclosure, in order to increase the computational speed in the MSMD model, the extended reference model is constructed by performing form factor prediction with a GH-MSMD model using a G parameter and an H parameter.

The G parameter is a state quantity that represents the sensitivity of the terminal voltage to the change in applied current of the battery in use, and has a unit of resistance.

The H parameter is an effective potential determined by the distribution of local equilibrium potential and the distribution of resistance within the battery in use.

The G and H parameters of the battery may be quantified as explicit correlations between battery material properties and design variables using theoretical models, and the internal state is able to be estimated from the parameters.

### CONSTRUCTION OF PREDICTION MODEL FOR EACH PROCESS COMPLETION SAMPLE

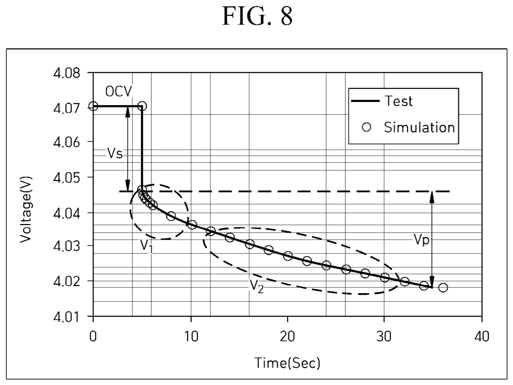

FIG. 8 is a profile data analysis graph of the prediction model for each process completion sample according to the embodiment of the present disclosure.

Vs is an RS parameter dominant, and Vp is an RP parameter dominant. By analyzing profile data, parameter-specific distribution is applicable in relation to the effect of resistance.

According to the embodiment of the present disclosure, performance characteristics for each sample are extracted based on the formation process evaluation data, and a model for each cell is characterized and updated, which is applied to the evaluation of the cell. It is possible to determine the risk of the cell through the simulation of the characterized and updated model. In FIG. 8, Vs represents an initial voltage drop region in which the voltage steps down from an open-circuit voltage (OCV) immediately after interruption of the applied current, and reflects a resistance characteristic dominated by an Rs component. Vp represents a voltage difference between the OCV and a quasi-steady-state voltage after a certain period of time has elapsed, and reflects a polarization resistance characteristic dominated by an Rp component. As shown in FIG. 8, V₁ denotes a short-term voltage response region observed immediately after the current is cut off, which represents an instantaneous voltage drop and recovery behavior dominated by Rs, and V₂ denotes a gradual voltage relaxation region appearing in a subsequent time interval, which represents polarization and diffusion-governed behavior dominated by Rp. Accordingly, by separately analyzing V₁ and V₂, it is possible to decompose Rs- and Rp-related resistance effects for each sample and apply them to parameters of the model. According to an embodiment of the present disclosure, performance characteristics for each sample are extracted based on formation process evaluation data, and the model for each cell is characterized and updated, and then applied to cell evaluation. Through simulation using the characterized and updated model, it is possible to determine a risk of the cell.

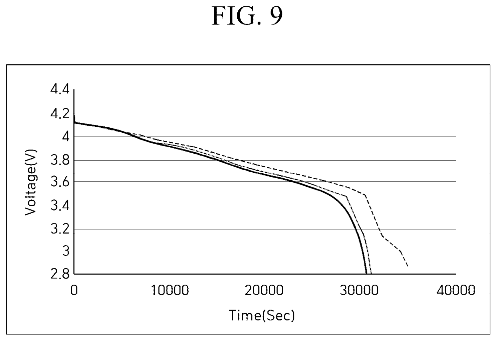

FIG. 9 is a graph related to consistency improvement using the prediction model for each process completion sample according to the embodiment of the present disclosure.

FIG. 9 illustrates that it is changeable to a result more similar to actual measurement values in the reference cell by applying characteristics for each sample to apply the differential resistance effect for each sample.

FIG. 9 illustrates the result of conformity improvement achieved by applying the process-completed, sample-specific prediction model according to an embodiment of the present invention. In the graph, three curves-represented as a thick solid line, a thin solid line, and a dashed line-are compared to demonstrate the improvement effect. The thick solid line corresponds to the voltage profile measured from an actual cell after completion of the manufacturing process. This curve reflects the real charge-discharge behavior of the battery cell and serves as the reference against which the simulation models are evaluated. In contrast, the thin solid line represents the simulation output generated using only the baseline reference model under the same conditions. Because this model does not incorporate sample-specific characteristics or process-induced variations, deviations from the measured profile occur in certain regions. Particularly in the mid-to-late stage of discharge, where the state of charge decreases, the thin solid line shows a discrepancy in the voltage drop pattern compared to the measured curve, indicating that the baseline reference model alone is not sufficient to capture real-cell behavior. The dashed line, on the other hand, shows the simulation result obtained after applying the sample-specific prediction model constructed using process-completed measurement data. This model incorporates sample-dependent characteristics, such as resistance deviations, into its parameters. As a result, the dashed line more closely follows the measured profile (thick solid line) over the entire time range. The overall error between simulation and measurement is significantly reduced, and both the slope of the voltage decline and the end-of-discharge behavior resemble the real cell much more accurately. Accordingly, FIG. 9 clearly demonstrates that, when compared against the thick solid line (measured data), the dashed line (sample-specific model) exhibits far better conformity than the thin solid line (baseline reference model). This confirms that incorporating sample-specific characteristics particularly differential resistance effects-substantially improves prediction accuracy, thereby showing that the process-completed sample-specific prediction model provides a meaningful enhancement in battery cell performance evaluation.

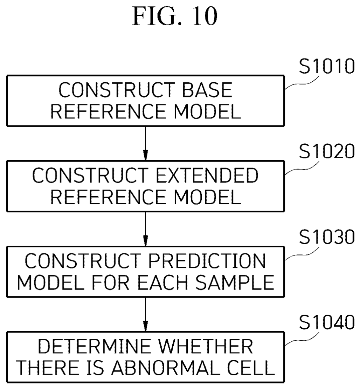

FIG. 10 illustrates a method of analyzing battery cell performance according to an embodiment of the present disclosure.

The method of analyzing battery cell performance according to the present disclosure includes a step of constructing a base reference model for analysis of battery cell performance (S1010), a step of constructing an extended reference model by exchanging data with process equipment (S1020), a step of constructing a prediction model for each sample based on formation process evaluation data (S1030), and a step of determining whether there is an abnormal cell using the base reference model, the extended reference model, and the prediction model for each sample (S1040).

In step S1010, the base reference model is constructed based on cell data accumulated before mass production.

In step S1020, the extended reference model is constructed based on process-specific measurement data.

The process-specific measurement data may include at least one of formation process data, drying process data, and mixing process data. If the formation process data is used, all electrical and thermal behaviors that occur during inter-cell formation may be measured and utilized for deviation analysis. If the drying process data is used, all data used for drying process analysis, including drying environments or the like, may be used. If the mixing process data is used, data containing the characteristics per every lot occurring for each lot may be used.

In step S1020, the extended reference model is constructed based on at least one of cell information, plate information, and form factor information.

In step S1030, performance characteristics for each sample are extracted based on the formation process evaluation data, and the prediction model for each sample that is specialized for battery cells is constructed.

In step S1040, risk factor information including at least one of output, heating, and deterioration information is output to output a result of determination of whether there is an abnormal cell.

In step S1040, if the result of abnormal cell determination using the base reference model does not match the result of abnormal cell determination using the extended reference model, a final evaluation result is output by giving relatively high reliability to the result of abnormal cell determination using the extended reference model.

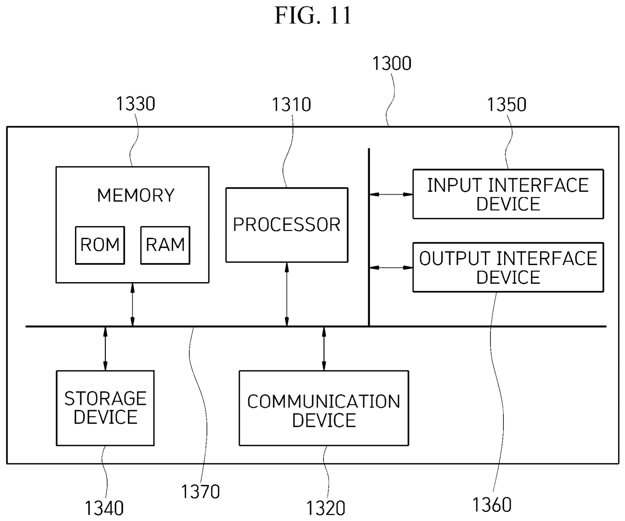

FIG. 11 is a block diagram illustrating a computer system for implementing the method according to the embodiment of the present disclosure.

Referring to FIG. 11, the computer system 1300 may include at least one of a processor 1310, a memory 1330, an input interface device 1350, an output interface device 1360, and a storage device 1340 communicating with one another through a bus 1370. The computer system 1300 may also include a communication device 1320 coupled to a network. The processor 1310 may be or include a central processing unit (CPU) or a semiconductor device that executes instructions stored in the memory 1330 or in the storage device 1340. The memory 1330 and the storage device 1340 may include various types of volatile or nonvolatile storage media. For example, the memory may include a read-only memory (ROM) and a random access memory (RAM). In example embodiments of the present disclosure, the memory may be located inside or outside the processor, and may be connected to the processor through various known means. The memory is or includes various types of volatile or nonvolatile storage media, and for example, may include a read-only memory (ROM) or a random access memory (RAM).

The system for analyzing battery cell performance according to the embodiment of the present disclosure includes an input interface device 1350 that receives equipment data, a memory 1330 that stores a program for creating and managing a battery model for analysis of battery cell performance based on the equipment data, and a processor 1310 that executes the program. The processor 1310 determines whether there is an abnormal cell using the battery model including the base reference model and the extended reference model.

Accordingly, example embodiments of the present disclosure may be implemented as a method implemented in a computer or a non-transitory computer-readable medium storing computer-executable instructions. In an example embodiment, when executed by the processor, computer-readable instructions may perform a method according to at least one aspect of the present disclosure.

The communication device 1320 may transmit or receive wired signals or wireless signals.

Additionally, the method according to an example embodiment of the present disclosure may be implemented in the form of program instructions that can be executed through various computer means and recorded on a computer-readable medium.

The computer-readable medium may include program instructions, data files, data structures, etc., singly or in combination. The program instructions recorded on the computer-readable medium may be specially designed and configured for the example embodiments of the present disclosure, or may be known and usable by those skilled in the art of computer software. Computer-readable recording media may include a hardware device configured to store and perform program instructions. For example, the computer-readable recording media may be or include magnetic media such as hard disks, floppy disks, and magnetic tapes, optical media such as CD-ROMs and DVDs, magneto-optical media such as floptical disks, ROM, RAM, flash memory, etc. The program instructions may include not only machine language codes such as that generated by a compiler, but also high-level language codes that can be executed by a computer through an interpreter, etc.

Hereinafter, any material that may be usable for the secondary battery according to examples of the present disclosure will be described.

As the positive electrode active material, a compound capable of reversibly intercalating/deintercalating lithium (e.g., a lithiated intercalation compound) may be used. For example, at least one of a composite oxide of lithium and a metal such as at least one of cobalt, manganese, nickel, and combinations thereof may be used.

The composite oxide may be or include a lithium transition metal composite oxide, and examples thereof may include at least one of a lithium nickel-based oxide, a lithium cobalt-based oxide, a lithium manganese-based oxide, a lithium iron phosphate-based compound, a cobalt-free nickel-manganese-based oxide, or a combination thereof.

As an example, a compound represented by at least any one of the following formulas may be used: LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn₃X_{c}O_{2-α}D_{α} (0.90≤a≤1.8, 0≤b≤0.5, 0≤c≤0.5, 0<α<2); LiₐNi₃Co_{c}L¹_{d}GₑO₂ (0.90≤a≤1.8, 0≤b≤0.9, 0≤c≤0.5, 0≤d≤0.5, 0<e<0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); and LiₐFePO₄ (0.90≤a≤1.8).

In the above formulas: A is or includes at least Ni, Co, Mn, or a combination thereof; X is or includes at least Al, Ni, Co, Mn, Cr, Fe, Mg, Sr, V, a rare earth element, or a combination thereof; D is or includes at least O, F, S, P, or a combination thereof; G is or includes at least Al, Cr, Mn, Fe, Mg, La, Ce, Sr, V, or a combination thereof; and L1 is or includes at least Mn, Al, or a combination thereof.

A positive electrode for a lithium secondary battery may include a current collector and a positive electrode active material layer formed on the current collector. The positive electrode active material layer may include a positive electrode active material and may further include a binder and/or a conductive material.

The content of the positive electrode active material is in a range of about 90 wt% to about 99.5 wt% on the basis of 100 wt% of the positive electrode active material layer, and the content of the binder and the conductive material is in a range of about 0.5 wt% to about 5 wt%, respectively, on the basis of 100 wt% of the positive electrode active material layer.

The current collector may be or include aluminum (Al) but is not limited thereto.

The negative electrode active material may include a material capable of reversibly intercalating/deintercalating at least one of lithium ions, lithium metal, an alloy of lithium metal, a material capable of being doped and undoped with lithium, or a transition metal oxide.

The material capable of reversibly intercalating/deintercalating lithium ions may be or include a carbon-based negative electrode active material, which may include, for example, at least crystalline carbon, amorphous carbon, or a combination thereof. Examples of the crystalline carbon may include graphite, such as natural graphite or artificial graphite, and examples of the amorphous carbon may include at least one of soft carbon, hard carbon, a pitch carbide, a meso-phase pitch carbide, sintered coke, and the like.

A Si-based negative electrode active material or a Sn-based negative electrode active material may be used as the material capable of being doped and undoped with lithium. The Si-based negative electrode active material may be or include at least silicon, a silicon-carbon composite, SiOₓ (0 < x < 2), a Si-based alloy, or a combination thereof.

The silicon-carbon composite may be or include a composite of silicon and amorphous carbon. According to one example embodiment, the silicon-carbon composite may be in the form of a silicon particle and amorphous carbon coated on the surface of the silicon particle.

The silicon-carbon composite may further include crystalline carbon. For example, the silicon-carbon composite may include a core including crystalline carbon and silicon particle and an amorphous carbon coating layer on the surface of the core.

A negative electrode for a lithium secondary battery may include a current collector and a negative electrode active material layer disposed on the current collector. The negative electrode active material layer may include a negative electrode active material and may further include a binder and/or a conductive material.

For example, the negative electrode active material layer may include about 90 wt % to about 99 wt % of a negative electrode active material, about 0.5 wt % to about 5 wt % of a binder, and about 0 wt % to about 5 wt % of a conductive material.

A non-aqueous binder, an aqueous binder, a dry binder, or a combination thereof may be used as the binder. When an aqueous binder is used as the negative electrode binder, a cellulose-based compound capable of imparting viscosity may be further included.

As the negative electrode current collector, at least one of copper foil, nickel foil, stainless steel foil, titanium foil, nickel foam, copper foam, conductive metal-coated polymer substrate, and combinations thereof may be used.

An electrolyte for a lithium secondary battery may include a non-aqueous organic solvent and a lithium salt.

The non-aqueous organic solvent may constitute a medium through which ions involved in the electrochemical reaction of the battery can move.

The non-aqueous organic solvent may be or include at least a carbonate-based, an ester-based, an ether-based, a ketone-based, an alcohol-based solvent, an aprotic solvent, and may be used alone or in combination of two or more.

Depending on the type of lithium secondary battery, a separator may be present between the first electrode plate (e.g., the negative electrode) and the second electrode plate (e.g., the positive electrode). As the separator, at least polyethylene, polypropylene, polyvinylidene fluoride, or a multilayer film of two or more layers thereof may be used.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles such as at least one of Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and combinations thereof but is not limited thereto.

The organic material and the inorganic material may be mixed in one coating layer or may be in the form of a coating layer containing an organic material and a coating layer containing an inorganic material that are laminated on each other.

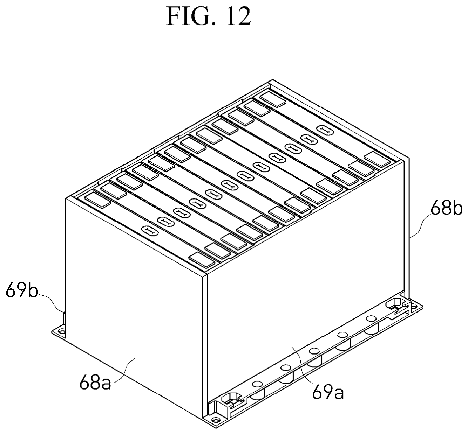

FIG. 12 is an illustration of a secondary battery module in which secondary batteries manufactured according to examples of the present disclosure are arranged. With the increase in secondary battery capacity for driving electric vehicles, and the like, a secondary battery module may be manufactured by arranging and connecting a plurality of secondary battery cells transversely and/or longitudinally. The plurality of secondary batteries may be arranged in a space defined by a pair of facing end plates 68a and 68b and a pair of facing side plates 69a and 69b. The secondary batteries may be designed appropriately in arrangement (direction) and number to obtain desired voltage and current specifications.

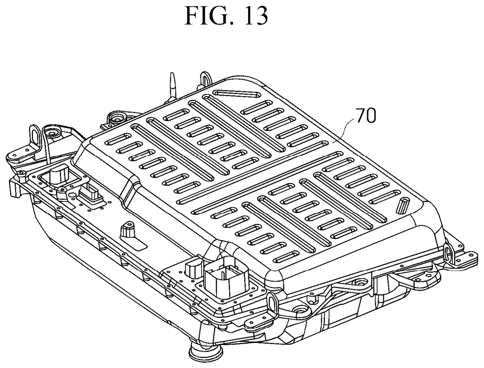

FIG. 13 is an illustration schematically showing the configuration of a battery pack 70 according to example embodiments of the present disclosure. Referring to FIG. 13, a battery pack 70 may include an assembly to which individual batteries are electrically connected, and a pack housing accommodating the same. In the drawings, for convenience of illustration, components including a bus bar, a cooling unit, external terminals for electrically connecting batteries, etc., are not shown.

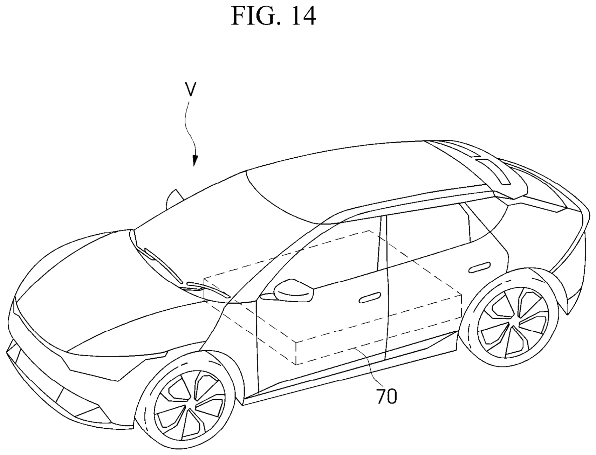

The battery pack 70 may be mounted on (or in) a vehicle. The vehicle may be, for example, an electric vehicle, a hybrid vehicle, a plug-in hybrid vehicle, and the like. The vehicle may be a four-wheeled vehicle or a two-wheeled vehicle but is not limited thereto. FIG. 14 shows a vehicle V which includes the battery pack 70 shown in FIG. 13 on the lower body thereof. The vehicle V may operate by (e.g., may be powered by) receiving power from the battery pack 70.

Although the present disclosure has been described herein with respect to example embodiments thereof, the present disclosure is not limited thereto. Various modifications and variations can be made thereto by those skilled in the art within the scope of the present disclosure as defined in the appended claims.

As is apparent from the above description, according to the present disclosure, it is possible to perform early determination on the presence or absence of cell abnormalities under different conditions by mixing cell information, plate information, form factor information, etc., which are accumulated during manufacturing of each cell, combining it with previously secured data to create the reference electrochemical model or equivalent circuit model of the cell, and continuously accumulating data during the process and improving the reference model.

According to the present disclosure, in the process equipment including automated modeling creation functions, it is possible to accumulate existing data and actual measurement data in the server in real time and continuously perform automatic model upgrades based on the real-time equipment data.

According to the present disclosure, it is possible to collect the formation process data to conduct risk analysis through high-speed evaluation tests, wherein even if it is determined that a cell is defective through the extended reference model based on the equipment measurement data at primary determination, if it is determined that the cell is not defective through the extended reference model based on the formation evaluation data at secondary determination, it can be ultimately determined that the cell is not defective.

## Claims

1. A system for analyzing battery cell performance, comprising:
a process equipment data management unit (520) configured to transmit equipment data;
a data analysis and model management unit (510) configured to create and manage, based on the equipment data, a battery model comprising a base reference model (511) and an extended reference model (512); and
a cell abnormality evaluation unit (530) configured to determine whether there is an abnormal cell using the battery model.

2. The system as claimed in claim 1, wherein the process equipment data management unit (520) collects and classifies the equipment data according to lot production progress, and converts and transmits the equipment data.

3. The system as claimed in claim 1 or 2, wherein the data analysis and model management unit (510) creates and manages the battery model comprising an electrochemical model and an equivalent circuit model.

4. The system as claimed in any one of the preceding claims, wherein the data analysis and model management unit (510) updates the battery model based on the result of battery evaluation.

5. The system as claimed in any one of the preceding claims,
wherein the data analysis and model management unit (510) constructs the base reference model (511) based on cell data accumulated before mass production; and/or
wherein the data analysis and model management unit (510) receives process-specific measurement data to construct the extended reference model (512); and/or
wherein the data analysis and model management unit (510) receives formation process measurement data to additionally create a prediction model for each sample (513).

6. The system as claimed in any one of the preceding claims, wherein the cell abnormality evaluation unit (530) determines whether there is an abnormal cell using the equipment data and the battery model, and transmits a result of the determination to an operator terminal.

7. The system as claimed in any one of the preceding claims,
wherein the data analysis and model management unit (510) creates the extended reference model (512) based on at least one of cell information, plate information, and form factor information, which are accumulated during manufacturing of cells; and/or
wherein the data analysis and model management unit (510) outputs a different model for each sample by a digital twin application.

8. The system as claimed in any one of the preceding claims, wherein the cell abnormality evaluation unit (530) outputs risk factor information comprising at least one of output, heating, and deterioration information.

9. The system as claimed in any one of the preceding claims, wherein, if a result of defective cell determination using the extended reference model (512) based on the equipment data does not match a result of defective cell determination using the extended reference model (512) based on formation evaluation data, the cell abnormality evaluation unit (530) performs final defective cell determination by giving relatively high reliability to the formation evaluation data.

10. A method of analyzing battery cell performance, comprising:
(a) constructing a base reference model (511) for analysis of battery cell performance;
(b) constructing an extended reference model (512) by exchanging data with process equipment;
(c) constructing a prediction model for each sample (513); and
(d) determining whether there is an abnormal cell using the base reference model (511), the extended reference model (512), and the prediction model for each sample (513).

11. The method as claimed in claim 10, wherein, in the step of (a) constructing a base reference model (511), the base reference model (511) is constructed based on cell data accumulated before mass production.

12. The method as claimed in claim 10 or 11, wherein, in the step of (b) constructing an extended reference model (512):
the extended reference model (512) is constructed based on process-specific measurement data; and/or
the extended reference model (512) is constructed based on at least one of cell information, plate information, and form factor information.

13. The method as claimed in any one of claims 10 to 12, wherein, in the step of (c) constructing a prediction model for each sample (513), performance characteristics for each sample are extracted based on formation process evaluation data, and the prediction model for each sample (513) is constructed that is specialized for battery cells.

14. The method as claimed in any one of claims 10 to 13, wherein, in the step of (d) determining whether there is an abnormal cell:
a result of the determination of whether there is an abnormal cell is output by outputting risk factor information comprising at least one of output, heating, and deterioration information; and/or
if a result of abnormal cell determination using the base reference model (511) does not match a result of abnormal cell determination using the extended reference model (512), a final evaluation result is output by giving relatively high reliability to the result of abnormal cell determination using the extended reference model (512).

15. A system for analyzing battery cell performance, comprising:
an input interface device (1350) configured to receive equipment data;
a memory (1330) configured to store a program for creating and managing a battery model for analysis of battery cell performance based on the equipment data by implementing a method of analyzing battery cell performance as claimed in any one of claims 10 to 14; and
a processor (1310) configured to execute the program,
wherein the processor (1310) is configured to determine whether there is an abnormal cell using the battery model comprising a base reference model (511) and an extended reference model (512).
